# EUROPEAN PATENT APPLICATION

(11) **EP 4 667 990 A1**
(43) Date of publication of application: **24.12.2025**
(21) Application number: 25182050.2
(22) Date of filing: 11.06.2025
(51) Int. Cl.: G02B 6/42, H01L 23/00

(54) **PHOTONIC INTEGRATED CIRCUIT AND METHOD FOR MANUFACTURING**

(30) Priority: 18.06.2024 DE 102024117104
(71) Applicant: LiGenTec SA, 1024 Ecublens (CH)
(72) Inventor: Op de Beeck, Camiel, 9000 Gent (BE); Sacchetto, Davide, 1462 Yvonand (CH)
(74) Representative: Isarpatent

(57) **Abstract**

The present invention provides a photonic integrated circuit comprising a stack of layers including: a substrate having a top surface on a front side and a back surface opposing the top surface on a back side, a functional layer disposed on the top surface, the functional layer comprising a photonic structure including at least one heater, wherein the heater is configured as a phase shifter, a dielectric layer disposed on the back surface, wherein the dielectric layer includes at least one opening through which the substrate is exposed, wherein a size of the opening and a location of the opening in the dielectric layer are selected for reducing a bow of the substrate caused by the deposition of the functional layer to the substrate. Further the present invention provides a method for manufacturing a photonic integrated circuit as well as.

## Description

### TECHNICAL FIELD OF THE INVENTION

The invention relates to a photonic integrated circuit as well as to a method for manufacturing a photonic integrated circuit.

### TECHNICAL BACKGROUND

Photonic chips designed for quantum computing typically include tunable interferometers driven by phase shifters for switching purposes. These circuits can scale very rapidly in size for more powerful circuits with more "quantum modes" or qubits. Therefore, the number of input and output fibers increases, and the number of heaters employed in the phase shifters also rapidly increases. Therefore, there is a need to enable the packaging of the photonic chips with no or very low bow or warpage for the Photonic Integrated Circuit (PIC) including the fiber-waveguide coupler interface attachment and low thermal resistance from the silicon substrate to the package. Photonic integrated circuits fabricated in dielectrics-based technologies often have a silicon dioxide layer at the backside of the wafer The standard dicing method does not remove this oxide layer at the back of the chip and is hence not a viable solution with respect to the heat sinking of the heaters.

US 11,935,842 B2 describes a method of manufacturing a semiconductor device by tuning a stress layer by a series of concentric annular regions for warpage reduction.

Therefore, it is an objective of the invention to provide PIC having low warpage. A further objective of the present invention is to provide a PIC having good thermal conductivity from the substrate to the package.

### SUMMARY OF THE INVENTION

According to the invention, this problem is solved in each case by the subject matters of the independent claims.

According to a first aspect of the invention, a photonic integrated circuit is provided. The photonic integrated circuit comprises a stack of layers including: a substrate having a top surface on a front side and a back surface opposing the top surface on a back side, a functional layer disposed on the top surface, the functional layer comprising a photonic structure including at least one heater, wherein the heater is configured as a phase shifter, a dielectric layer disposed on the back surface, wherein the dielectric layer includes at least one opening through which the substrate is exposed, wherein a size of the opening and a location of the opening in the dielectric layer are selected for reducing a bow of the substrate caused by the deposition of the functional layer to the substrate.

According to a second aspect of the invention, a method for manufacturing a photonic integrated circuit is provided. The method for manufacturing a photonic integrated circuit comprises providing a substrate having a a top surface on a front side and a back surface on a back side, disposing on the top surface of a substrate a functional layer comprising a photonic structure including at least one heater, wherein the the heater is configured as a phase shifter, disposing a dielectric layer on the back surface of the substrate, etching a part of the dielectric layer to form at least one opening through which the substrate is exposed, wherein a size of the opening and a location of the opening in the dielectric layer are selected for reducing a bow of the substrate caused by the deposition of the functional layer to the substrate.

A trivial solution for increasing thermal conductivity for the functional layer to the back side would be to remove the entire dielectric layer from the substrates. This is because the substrate regularly has a higher conductivity than the dielectric layer, since the substrate typically is made of Si or a III-V semiconductor. However, removing the oxide layer would create too large mechanical bow or warpage of the substrate, which may form the main chip or a die area, to adjust the bow of the substrate due to the asymmetry between the front side and the backside layers.

It is therefore a fundamental concept of this disclosure to envisage a dedicated partial removal of the dielectric backside, in particular at regions aligned with heating elements present on the front side, thus allowing for efficient thermal management of the thermo-optical devices while keeping and controlling the mechanical bow and warpage to the required labels for the device or the die packaging.

As for the functional layer deposited on the front side of the substrate, it is understood that the functional layer regularly includes a plurality of layers, which are regularly composed of dielectric materials to form cladding and core parts of the photonic structure. For example, SiO₂ and Si₃N₄ are suitable materials for cladding and core parts since these provide a high refractive index contrast. However, the deposition of silicon oxide onto the substrate, which can be, for example, Si or InP, induces mechanical stress to the substrate resulting in a bow or warpage of the substrate.

In addition, thick dielectric layers are usually required on the front side of the wafer or substrate for stability and guiding purposes of the photonic structure. To keep the values of a bow or warpage of diced chips to values acceptable for packaging requirements, it is regularly preferred to keep the same layer materials and thicknesses on the backside of the wafer for the dielectric layer. Furthermore, there is a manufacturing advantage to depositing the dielectric layer on the front and back side of the substrate at the same time.

However, low refractive index dielectrics are typically employed for the photonic structure of the functional layer. Typically, these layers have poor thermal conductivity. Dielectric loss and thermal conductivity in materials are generally associated with increased photon absorption, which is an unsuitable property for low loss photonic integrated circuits. For example, good dielectric materials such as glass have extremely low electrical and thermal conductivity, and at low frequencies the dielectric loss is also negligible, resulting in almost no absorption. These features make glasses such as amorphous SiO₂ applicable as a cladding material for the photonic structure as well.

Photonic integrated circuits with such thick dielectric thin-films have an advantageous low optical loss when compared with semiconductor-based counterparts. The drawback though is poor thermal conductivity, which can impact the photonic integrated devices in the photonic infrastructure. In addition, the photonic integrated circuit includes a heater as one example of an integrated device having a thermo-optical dependence. Such a heater is configured as a phase shifter, which means that a phase shift can be created as a function of the amount of heat provided by the heater in order to delay at least one channel waveguide of the photonic structure. Such channel waveguide may be integrated in an interferometer comprising at least two channel waveguides that interfere with each other. These interferometers are particularly useful for optical switches and other functions in quantum computing.

A particular advantage of the solution according to an aspect of the invention is that by the proposed method and the corresponding PIC allows controlling the bow of the substrate to obtain, at least in one dimension of the substrate, no or only a minimum bow for optimum thermal contact with the package. On the other hand, by partially removing the dielectric layer, the substrate and the functional layer become more accessible for thermal dissipation of heat created in the functional layer. In a typical package, the openings are filled with a thermal paste, which has a higher thermal conductivity than the dielectric layer to thermally connect the substrate to a package structure, where the heat can dissipate. In this way, heat created in the functional layer can be dissipated more effectively, allowing a more dense applicability of devices exploiting thermo-optical dependence.

According to some further aspects of the photonic integrated circuit according to the invention, the dielectric layer includes a single opening arranged in a central position on the substrate, wherein the dielectric layer is frame-shaped arranged around the opening. The manufacturing of this design is simple, and the single opening provides a reasonable effect on the bow while providing the possibility of thermal contact at the center of the substrate for effective cooling, e.g., by connecting the substrate by thermal paste to a heat sink.

According to some further aspects of the photonic integrated circuit according to the invention, the single opening has a rectangular shape. In such embodiment, the dielectric layer is rectangular frame-shaped as well. This further optimizes the bow reduction and the provision of thermal conductivity to the substrate.

According to some further aspects of the photonic integrated circuit according to the invention, the dielectric layer comprises a plurality of randomly arranged openings. This design is relatively simple to fabricate, having rather few restrictions. Furthermore, by having a large amount of rather small-sized openings, the amount of stress for bow compensation and/or thermal conductivity can be controlled by simple parameters. It thus improves simplicity of the photonic integrated circuit.

According to some further aspects of the photonic integrated circuit according to the invention, the dielectric layer includes a regular pattern of a plurality of openings. By these features, the pattern can be manufactured in a simple and reliable way. Furthermore, the processing allows for controlling the amount of bow and heat conductivity by parameters of the regular pattern, which can be e.g. a size of the opening or a periodicy.

According to some further aspects of the photonic integrated circuit according to the invention, the plurality of openings is formed as trenches, wherein the trenches are formed parallel to a trench of a fiber-waveguide coupler of the photonic structure. The fiber-waveguide coupler is a type of edge coupler that may have one or more V-grooves for placing a fiber for coupling light from the fiber into the waveguide of the photonic structure and vice versa. In this way, stress and bow at the location of the coupling element can be reduced, which leads to a better coupling efficiency between the one or more fibers and the waveguides of the photonic structure.

According to some further aspects of the photonic integrated circuit according to the invention, the regular pattern is a periodic pattern having circular openings with a predetermined periodicity. Since this design creates homogeneous stress, such a pattern is particularly effective for compensating the bow of the substrate. Furthermore, fabrication of circular openings can be made with rather simple and low-cost tools.

According to some further aspects of the photonic integrated circuit according to the invention, the regular pattern is a two-dimensional check pattern, wherein the predetermined periodicity of the openings is larger than 1/mm. This pattern allows further controlling the periodicity for controlling the amount of stress for bow compensation and thermal conductivity. Furthermore, due to the small periodicity, stress is applied homogeneously on the substrate so that unevenness on the substrate and thus the stack of layers is avoided or at least reduced.

According to some further aspects of the photonic integrated circuit according to the invention, the openings of the regular pattern penetrate at least partly into the substrate. This guarantees a good thermal contact between a material filling the openings to the substrate. Since the substrate regularly possesses a high thermal conductivity, an efficient dissipation of heat created in the functional layer to the back side can be ensured. The openings may also penetrate into the functional layer, which further allows the possibility to improve the heat flow from the heater to the back side.

According to some further aspects of the photonic integrated circuit according to the invention, the stack of layers further comprises a conductive layer arranged as a bottom layer on the back side of the substrate. The conductive layer fills, at least partly, the at least one opening. The conductive layer increases the capability of heat dissipation from the heater integrated in the photonic structure to the back side of the stack of layers. By the present embodiment, due to the increased heat dissipation away from the photonic structure, the density of phase shifters and/or the reaction time of the phase shifter can be increased significantly.

According to some further aspects of the photonic integrated circuit according to the invention, the at least one opening penetrates the dielectric layer and the substrate into the functional layer. The at least one first opening is filled with a conductive material. In particular, a location of the at least one opening may correspond to a location of the heater in the functional layer. The opening thus penetrates not only through the dielectric layer but also through the substrate into and a part of the functional layer. After filling the opening with conductive material such as a metal or thermal paste, heat can flow directly from the heater of the photonic structure of the functional layer to the backside of the stack of layers. The location of the opening may be designed such that it is in the vicinity of the heater in a plane orthogonal to the top surface of the substrate. In this way, the path for heat dissipation is reduced for more efficient heat dissipation.

According to some further aspects of the photonic integrated circuit according to the invention, the functional layer comprises a plurality of heaters. The plurality of openings includes at least one first opening, which penetrates the dielectric layer and the substrate to the functional layer. The at least one opening is filled with a conductive material. In particular, the locations of the first openings may correspond to a location of the heaters in the functional layer. This design optimizes the heat flow from away from the heaters to the back side of the stack of layers. For example, by fabricating such a hole for each heater, heat cross-talk in the photonic structure can be substantially reduced. In this way, the density of the heaters can be increased. Furthermore, the conductive material may also be in direct contact with the heater or the heater device leading to a further increase in heat dissipation.

According to some further aspects of the photonic integrated circuit according to the invention, an additional layer is disposed on the dielectric layer. A material of the additional layer and a material of the dielectric layer is different. Furthermore, a material of the additional layer and/or a thickness of the additional layer is selected for reducing the bow of the substrate. The material of the additional layer may be an oxide, such as SiO₂ or another material comprises a high compressive strength for bow reduction.

According to some further aspects of the photonic integrated circuit according to the invention, the photonic integrated circuit further comprises a heat sink attached to the bottom layer of the stack of layers. To ensure good thermal contact, thermal paste may be used to fill the openings and unevenness of the interface between the bottom layer of the stack of layers and the heat sink. Such a heat sink may be formed by copper, diamond, or another material or alloy having high conductivity. In this way, heat created in the functional layer can be dissipated very efficiently.

The above embodiments and further developments can be combined with each other as desired, if appropriate. In particular, all features of the photonic integrated circuit are transferable to the method for manufacturing the photonic integrated circuit, and vice versa. Other possible aspects, further developments and implementations of the invention also include combinations of features of the invention described above or below regarding the embodiment examples that are not explicitly mentioned. In particular, the skilled person will also add individual aspects as improvements or additions to the respective basic form of the present invention.

Advantageous embodiments and further developments emerge from the description with reference to the figures.

### BRIEF SUMMARY OF THE DRAWINGS

The present invention is explained more specifically below on the basis of the exemplary embodiments indicated in the schematic figures, in which:
- Fig. 1a-1e: shows schematic illustrations of steps during the manufacturing of a photonic integrated circuit according to an embodiment of the invention;
- Fig. 2: shows a schematic illustration of a photonic integrated circuit according to an embodiment of the invention;
- Fig. 3a-b: show a schematic illustration and a top view of a photonic integrated circuit according to a further embodiment of the invention;
- Fig. 4: show a top view of a photonic integrated circuit according to a further embodiment of the invention;
- Fig. 5: shows a top view of a photonic integrated circuit according to a further embodiment of the invention;
- Fig. 6a-c: show schematic illustrations of a photonic integrated circuit according to a further embodiment of the invention;
- Fig. 7: shows a schematic illustration of a photonic integrated circuit according to a further embodiment of the invention; and
- Fig. 8: shows a flow chart of a method for manufacturing of a photonic integrated circuit according to an embodiment of the invention.

The accompanying figures are intended to convey a further understanding of the embodiments of the invention. They illustrate embodiments and are used in conjunction with the description to explain principles and concepts of the invention. Other embodiments and many of the cited advantages emerge in light of the drawings. The elements of the drawings are not necessarily shown to scale in relation to one another. Direction-indicating terminology such as for example "at the top", "at the bottom", "on the left", "on the right", "above", "below", "horizontally", "vertically", "at the front", "at the rear" and similar statements are merely used for explanatory purposes and do not serve to restrict the generality to specific configurations as shown in the figures.

In the figures of the drawing, elements, features and components that are the same, have the same function and have the same effect are each provided with the same reference signs, unless explained otherwise.

### DESCRIPTION OF EMBODIMENTS

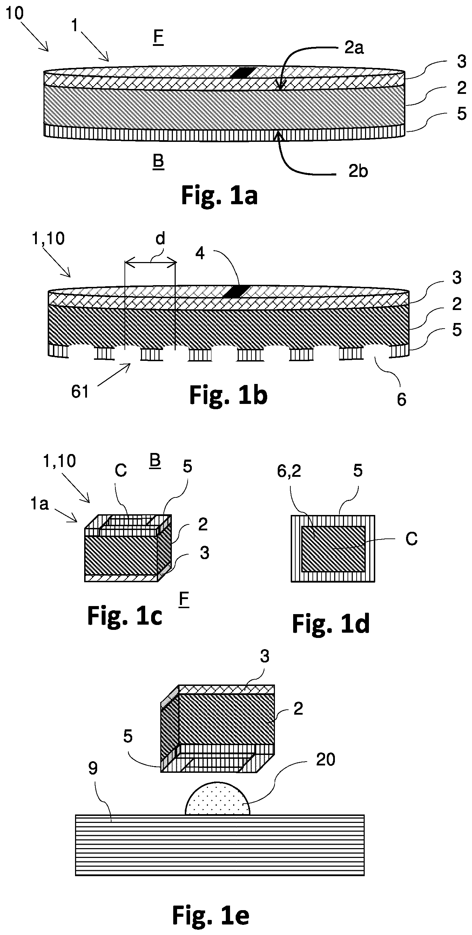

Fig. 1a-1e shows schematic illustrations of steps during the manufacturing of photonic integrated circuit 1 according to an embodiment of the invention.

In Fig. 1a to 1e, a fabrication process of a photonic integrated circuit 10 is shown. Fig. 1a shows a stack of layers 1. The stack of layers 1 includes a substrate 2 having a top surface 2a on a front side F and a back surface 2b opposing the top surface 2a on a back side B. The substrate may be, for example, a Si wafer of, e.g., 100 mm diameter. A functional layer 3 is disposed on the top surface 2a. The functional layer 3 comprises a photonic structure that includes at least one heater 4. The heater 4 is configured as a phase shifter in a photonic circuit, both not shown in Fig. 1. It is understood that the functional layer typically is composed of a plurality of layers of different materials for forming a core and cladding of the photonic structure. For example, a composition of SiO₂ and Si₃N₄ is suitable for this purpose due to the high refractive index contrast. The stack of layers 1 further comprises a dielectric layer 5, which is disposed on the back surface 2b of the substrate 2.

The dielectric layer 5 includes at least one opening 6 through which the substrate 2 is exposed. In the embodiment shown in Fig. 1b, the dielectric layer 5 includes a regular pattern 61 of a plurality of openings 6.

A size and a location of each of the at least opening 6 in the dielectric layer 5 are selected for reducing a bow of the substrate 2 caused by the deposition of the functional layer 3 to the substrate 2. Such openings 6 reduce the amount of stress compared to a dielectric layer 5 without any openings 6. In the present embodiment shown in Fig.1b, the regular pattern 61 is formed by a two-dimensional check pattern. The check pattern is designed such that a predetermined periodicity of the openings 6 is larger than 1/mm. This means that a distance d between neighboring openings 6 is less than 1 mm. In further embodiments, the regular pattern 61 is a periodic pattern having circular openings 6 with a predetermined periodicity.

Fig. 1c and Fig. 1d show a perspective view and a top view of a die 1a of the stack of layers 1 after a dicing process. In these figures, the stack of layers 1 of the die 1a has been flipped so that so that the front side F is drawn at the bottom and the back side B is drawn at the top. This means that the dielectric layer 5 is now shown on the top and the functional layer 3 at the bottom. The dielectric layer 5 includes a single opening 6 arranged in a central position C on the substrate 2. In addition, the dielectric layer 5 is frame-shaped arranged around the opening 6. In the embodiment shown in Fig. 1c, the single opening 6 has a rectangular shape, wherein the dielectric layer 5 is rectangular frame-shaped.

In Fig. 1e, an embodiment of a manufacturing step shows a heat sink 9 that is to be attached to the bottom layer of the stack of layers 1. In this case, the bottom layer is the dielectric layer 5 of the stack of layers 1. In order to improve contact with the substrate 2, thermal paste 20 is used to fill the single opening 6 of the die 1a for thermally connecting the substrate 2 to the heat sink 9.

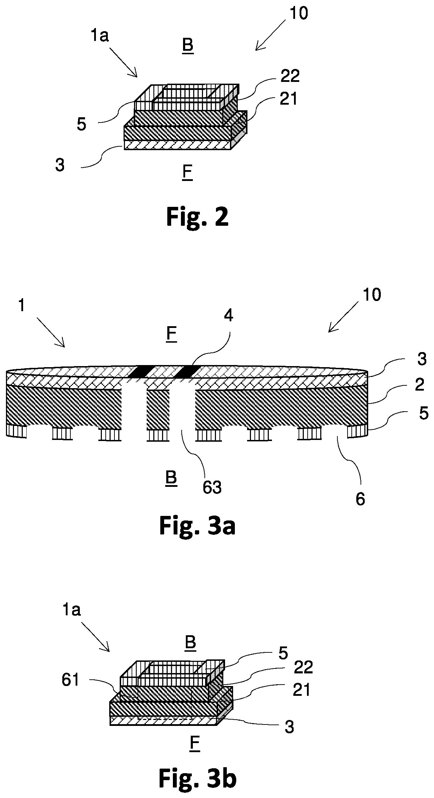

Fig. 2 shows a schematic illustration of a photonic integrated circuit according to an embodiment of the invention.

Fig. 2 shows a stack of layers 1 of a die 1a after a dicing process, that is generally optional in this manufacturing process. However, manufacturing a functional layers 3 including a plurality of photonic structures on one substrate 2, and then dicing the stack of layers 1 into dies 1a including a functional layer 3 including only one particular photonic structure, is cost saving and therefore commonly performed.

In the embodiment of the photonic integrated circuit 10 shown in Fig. 2, the substrate includes an upper part layer 21 and a lower part layer 22 that has a smaller area than the upper part. Similar to Fig. 1c to 1e, the stack of layers 1 is flipped so that the front side F is drawn at the bottom and the back side B is drawn at the top.

Fig. 3a-b show a schematic illustration and a top view of a photonic integrated circuit 10 according to a further embodiment of the invention.

The embodiment of the photonic integrated circuit 10 shown in Fig. 3a and 3b is based on and compatible with the previous embodiments described above with reference to Fig. 1a to 1e and 2. Fig. 3a shows a perspective view of a stack of layers 1 before a dicing process, and Fig. 3b shows one die 1a of the stack of layers 1 after the dicing process.

In the present embodiment of the photonic integrated circuit 10, the stack of layers 1 comprises a dielectric layer 5, which includes a regular pattern 61 of a plurality of openings 6 similar to the previous embodiment of Fig. 1. In addition, some openings 63 of the regular pattern penetrate at least partly into the substrate 2. The plurality of openings 6 thus includes firsts openings 63, which penetrate the dielectric layer 5 and the substrate 2 into the functional layer 3. A location of the first openings 63 corresponds to a location of a plurality of heaters 4 that are included in the photonic structure of the functional layer 3. In the present embodiment, the location of the first opening 6 are directly beneath the location of the heaters 4. In further embodiments, the location of the first opening 6 are nearby the location of the heaters 4.

In the final product of the photonic integrated circuit 10, the first opening 63 are filled with a conductive material such as a thermal paste 20 or an additional layer, that comprises a metal or other conductive material, as will be described later. Such a conductive material promotes the dissipation of heat from the heaters 4 to the back side B of the stack of layers 1. This allows a more dense application of heaters 4 and thus phase shifter and interferometers into the photonic structure of the functional layer 3.

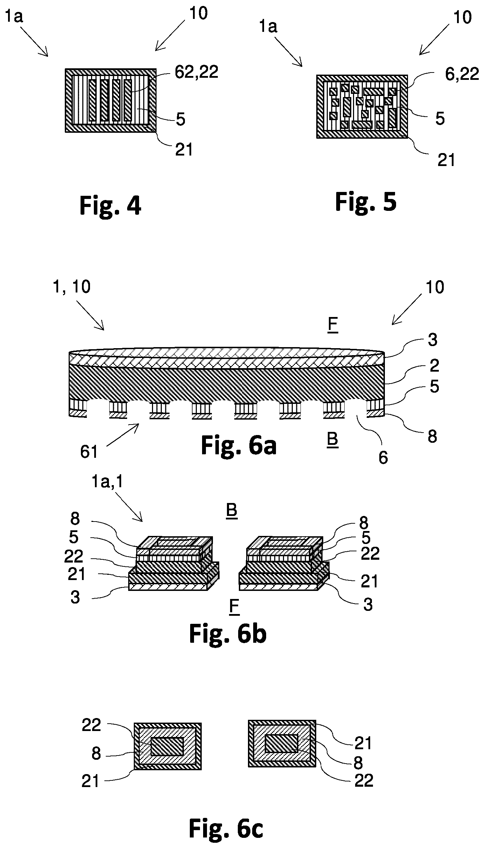

Fig. 4 show a top view of a photonic integrated circuit 10 according to a further embodiment of the invention.

The embodiment of the photonic integrated circuit 10 shown in Fig. 4 is based on and compatible with the previous embodiments described above with reference to Fig. 1 to 3.

In this embodiment, the die 1a of the stack of layer 1 of the photonic integrated circuit 1 itself includes a plurality of openings 6 in the dielectric layer 5. The openings 6 are formed as trenches 62. The trenches 62 are formed parallel to at least a part of trenches of a fiber-waveguide coupler (not shown) of the photonic structure formed in the functional layer 3. In Fig. 4 further shown is the upper part layer 21 of the substrate 2, which surrounds the trenches 62 and the dielectric layer 5 in the view of Fig. 4.

Fig. 5 shows a top view of a photonic integrated circuit 10 according to a further embodiment of the invention.

The embodiment of the photonic integrated circuit 10 shown in Fig. 5 is based on and compatible with the previous embodiments described above with reference to Fig. 1 to 3 as well.

In this embodiment, the dielectric layer 5 comprise a plurality of randomly arranged openings 6. Further shown is the upper part layer 21, of the substrate 2, which surrounds the trenches 62 and the dielectric layer 5 in the view of Fig. 5.

Fig. 6a-c show schematic illustrations of a photonic integrated circuit according to a further embodiment of the invention.

The embodiment of the photonic integrated circuit 10 shown in Fig. 6a to 6c is based on and compatible with the previous embodiments described above with reference to Fig. 1 to 5. Fig. 6a shows a perspective view of the stack of layers 1 of the photonic integrated circuit 10 before dicing. Fig. 6b show a pair of stack of layers 1 of photonic integrated circuits 10 after dicing, i.e. a pair of dies 1a. Fig. 6c shows a top view of the stack of layers 1 as shown in Fig. 6b.

Heaters 4 are not shown in any of the furhter figures for simplicity. However, it is understood that the photonic structure of the fucntional layers 3 in these embodiments also includes at least one heater 4 that is configured as a phase shifter.

In this embodiment, the stack of layers 1 includes an additional layer 8. The additional layer 8 is disposed on the dielectric layer 5, wherein a material of the additional layer 8. A material of the dielectric layer 5 is different. The material of the additional layer 8 and/or a thickness of the additional layer 8 is selected for reducing the bow of the substrate 2. The material of the additional layer 8 may be an oxide, such as SiO₂ or another material comprises a high compressive strength for bow reduction. The additional layer 8 has been deposited onto the dielectric layer 5 before etching the openings 6. That is why the additional layer does not penetrate into the openings 6, as can be seen in Fig. 6a. In further embodiments, the stack of layers 1 comprises more than one additional layer that are designed for bow reduction.

In the present embodiment of the photonic integrated circuit 10, the stack of layers 1 comprises a dielectric layer 5, which includes a regular pattern 61 of a plurality of openings 6 similar to the previous embodiments of Fig. 1 and 3.

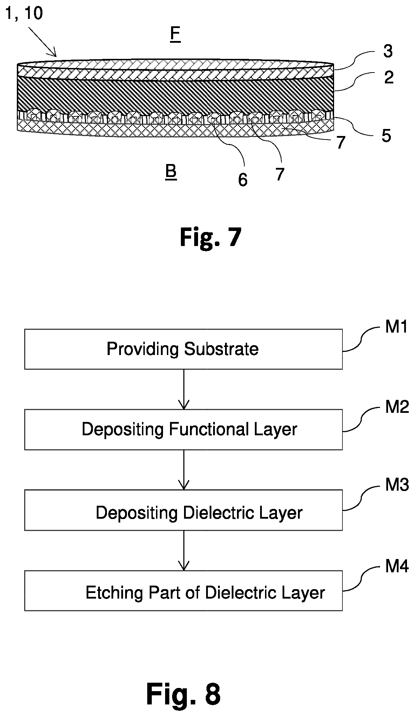

Fig. 7 shows a schematic illustration of a photonic integrated circuit according to a further embodiment of the invention.

The embodiment of the photonic integrated circuit 10 shown in Fig. 7 is based on and compatible with the previous embodiments described above with reference to Fig. 1 to 6.

In Fig. 7, an additional conductive layer 7 is arranged as a bottom layer of the stack of layer 1 on the back side B of the substrate 2. The conductive layer at least partly filling the at least one opening 6. In some embodiments, a material of the conductive layer is a metal. In some of these embodiments, the material is aluminum. However, the conductive layer 7 is not limited to aluminium as metal.

In further embodiments, the concept shown in Fig. 3 is combined with the conductive layer 7. In these embodiments, the at least one opening 6 penetrates the dielectric layer 5 and the substrate 2 to the functional layer 3. In such embodiments, the at least one first opening 63 is filled with a conductive material, i.e. by the conductive layer 7. In some of these embodiments, a location of the at least one opening 6 corresponds to a location of the heater 4 in the functional layer 3. In some embodiments, the conductive layer 7 planarizes the openings 6 for optimum heat flow to a heat sink 9 or other heat dissipation devices. In other embodiments, the thickness of the conducitve layer is less than a depth of the opening so that a bottom surface on the bottom side B of the stack of layers 1 is not planarized.

In some of these embodiments, the functional layer 3 comprises a plurality of heaters 4 and a plurality of openings 6. The plurality of openings 6 includes at least one first opening 63, which penetrates the dielectric layer 5 and the substrate 2 into the functional layer 3. The at least one first opening 63 is filled with the conductive material of the conductive layer 7. In some embodiments, all openings 6 penetrates the dielectric layer 5 and the substrate 2 into the functional layer 3. In these embodiments, all openings are filled with the conductive material of the conductive layer 7. In some of these embodiments, a location of the first openings 63 corresponds to a location of the heaters 4 in the functional layer 3. In some of these embodiments, a location of first openings 63 corresponds to a location of the heaters 4 in the functional layer 3.

It is understood that the concept of the embodiment shown in Fig. 6 can be combined with the present embodiment of Fig. 7 such that an additional layer 8 is arranged between the dielectric layer 5 and the conductive layer 7.

Fig. 8 shows a flow chart of a method for manufacturing of a photonic integrated circuit according to an embodiment of the invention.

In the method for manufacturing a photonic integrated circuit 10, a substrate 2 having a a top surface 2a on a front side F and a back surface 2b on a back side B is provided in step M1. A functional layer 3 compring a photonic structure including at least one heater 4 is disposed on the top surface 2a of a substrate 2 in step M2. The heater 4 is configured as a phase shifter, which means that applied heat to the heater is creating a phase shift in a waveguide of, e.g., an interferometer. A dielectric layer 5 is disposed on the back surface 2b of the substrate 2 in step M3. In Step M4, a part of the dielectric layer 5 is etched to form at least one opening 6 through which the substrate 2 is exposed. A size of the opening 6 and a location of the opening 6 in the dielectric layer 5 are selected for reducing a bow of the substrate 2 caused by a deposition of the functional layer 3 to the substrate 2.

In the detailed description above, various features have been combined in one or more examples in order to improve the rigorousness of the illustration. However, it should be clear in this case that the above description is of merely illustrative but in no way restrictive nature. It serves to cover all alternatives, modifications, and equivalents of the various features and exemplary embodiments. Many other examples will be immediately and directly clear to a person skilled in the art on the basis of his knowledge in the art in consideration of the above description.

The exemplary embodiments have been chosen and described in order to be able to present the principles underlying the invention and their application possibilities in practice in the best possible way. As a result, those skilled in the art can optimally modify and utilize the invention and its various exemplary embodiments with regard to the intended purpose of use. In the claims and the description, the terms "including" and "having" are used as neutral linguistic concepts for the corresponding terms "comprising". Furthermore, use of the terms "a", "an" and "one" shall not in principle exclude the plurality of features and components described in this way.

While at least one exemplary embodiment of the present inventions is disclosed herein, it should be understood that modifications, substitutions and alternatives may be apparent to one of ordinary skill in the art and can be made without departing from the scope of this disclosure. This disclosure is intended to cover any adaptations or variations of the exemplary embodiments. In addition, in this disclosure, the terms "comprise" or "comprising" do not exclude other elements or steps, the terms "a" or "one" do not exclude a plural number, and the term "or" means either or both. Furthermore, characteristics or steps which have been described may also be used in combination with other characteristics or steps and in any order unless the disclosure or context suggests otherwise. This disclosure hereby incorporates by reference the complete disclosure of any patent or application from which it claims benefit or priority.

### LIST OF USED REFERENCE SIGNS

- 1: stack of layers
- 1a: die
- 2: substrate
- 2a: top surface
- 2b: back surface
- 3: functional layer
- 4: heater
- 5: dielectric layer
- 6: opening
- 7: conductive layer
- 8: additional layer
- 9: heat sink
- 10: photonic integrated circuit
- 20: thermal paste
- 21: upper part layer of the substrate
- 22: lower part layer of the substrate
- 61: regular pattern
- 62: trenches
- 63: first openings
- B: back side
- C: center
- F: front side
- M1-M4: Method steps
- d: distance between neighboring openings

## Claims

1. Photonic integrated circuit (10), comprising a stack of layers (1) including:
a substrate (2) having a top surface (2a) on a front side (F) and a back surface (2b) opposing the top surface (2a) on a back side (B),
a functional layer (3) disposed on the top surface (2a), the functional layer (3) comprising a photonic structure including at least one heater (4), wherein the heater (4) is configured as a phase shifter,
a dielectric layer (5) disposed on the back surface (2b),
wherein the dielectric layer (5) includes at least one opening (6) through which the substrate (2) is exposed, wherein a size of the opening (6) and a location of the opening (6) in the dielectric layer (5) are selected for reducing a bow of the substrate (2) caused by the deposition of the functional layer (3) to the substrate (2).

2. Photonic integrated circuit according claim 1, wherein the dielectric layer (5) includes a single opening arranged in a central position (C) on the substrate (2), wherein the dielectric layer (5) is frame-shaped arranged around the opening (6).

3. Photonic integrated circuit according to claim 2, wherein the single opening has a rectangular shape, wherein the dielectric layer (5) is rectangular frame-shaped.

4. Photonic integrated circuit according to any of the previous claims, wherein the dielectric layer (5) comprise a plurality of randomly arranged openings (6).

5. Photonic integrated circuit according to any of the claims 1 to 3, wherein the dielectric layer (5) includes a regular pattern (61) of a plurality of openings (6).

6. Photonic integrated circuit according to claim 5, wherein the plurality of openings (6) is formed as trenches (62), wherein the trenches (62) are formed parallel to at least a part of a fiber-waveguide coupler of the photonic structure.

7. Photonic integrated circuit according to claim 5, wherein the regular pattern (61) is a periodic pattern having circular openings (6) with a predetermined periodicity.

8. Photonic integrated circuit according to claim 7, wherein the regular pattern (61) is a two-dimensional check pattern, wherein the predetermined periodicity of the openings (6) is larger than 1/mm.

9. Photonic integrated circuit according to any claims 5 to 8, wherein the openings (6) of the regular pattern penetrate at least partly into the substrate (2).

10. Photonic integrated circuit according to any of the previous claims, wherein the at least one first opening (6) penetrates the dielectric layer (5) and the substrate (2) to the functional layer (3), wherein the at least one opening (6) is filled with a conductive material, wherein a location of the at least one opening (6) in particular corresponds to a location of the heater (4) in the functional layer (3).

11. Photonic integrated circuit according to any of claims 5 to 9, wherein the functional layer (3) comprises a plurality of heaters (4), wherein the plurality of openings (6) includes at least one first opening (63), which penetrates the dielectric layer (5) and the substrate (2) to the functional layer (3), wherein the at least one first opening (63) is filled with a conductive material, wherein a location of the first openings (63) in particular corresponds to a location of the heaters (4) in the functional layer (3).

12. Photonic integrated circuit according to any of the previous claims, the stack of layers (1) further comprising a conductive layer (7) arranged as a bottom layer on the back side (B) of the substrate (2), the conductive layer (7) at least partly filling the at least one opening (6).

13. Photonic integrated circuit according to any of the previous claims, wherein an additional layer (8) is disposed on the dielectric layer (5), wherein a material of the additional layer (8) and a material of the dielectric layer (5) is different, wherein a material of the additional layer (8) and/or a thickness of the additional layer (8) is selected for reducing the bow of the substrate (2).

14. Photonic integrated circuit according to any of the previous claims, further comprising a heat sink (9) attached to the bottom layer of the stack of layers (1).

15. Method for manufacturing a photonic integrated circuit (10), comprising providing (M1) a substrate (2) having a a top surface (2a) on a front side (F) and a back surface (2b) on a back side (B),
disposing (M2) on the top surface (2a) of a substrate (2) a functional layer (3) comprising a photonic structure including at least one heater (4), wherein the the heater (4) is configured as a phase shifter,
disposing (M3) a dielectric layer (5) on the back surface (2b) of the substrate (2), etching (M4) a part of the dielectric layer (5) to form at least one opening (6) through which the substrate (2) is exposed, wherein a size of the opening (6) and a location of the opening (6) in the dielectric layer (5) are selected for reducing a bow of the substrate (2) caused by a deposition of the functional layer (3) to the substrate (2).
